# EUROPÄISCHE PATENTSCHRIFT

(11) **EP 2 099 134 B1**
(45) Veröffentlichungstag und Bekanntmachung des Hinweises auf die Patenterteilung: **23.05.2012**
(21) Anmeldenummer: 08004168.4
(22) Anmeldetag: 06.03.2008
(51) Int. Cl.: H03K 17/95

(54) **Verfahren zum Erkennen eines Vorbedämpfungszustands und induktiver Sensor mit Vorbedämpfungserkennung**
Method for recognising a pre-attenuation of an inductive sensor and inductive sensor
Procédé de détection d'un état de préattenuation d'un capteur inductif et capteur inductif

(43) Veröffentlichungstag der Anmeldung: 09.09.2009
(73) Patentinhaber: Pepperl + Fuchs GmbH, 68307 Mannheim (DE)
(72) Erfinder: Kühn, Thomas, 68219 Mannheim (DE)
(74) Vertreter: Schiffer, Axel Martin

(56) Entgegenhaltungen:
- EP-A- 0 304 272
- WO-A-00/43728
- US-B1- 6 342 805
- US-B1- 7 173 411

## Beschreibung

Die vorliegende Erfindung betrifft gemäß einem ersten Aspekt ein Verfahren zum Erkennen eines Vorbedämpfungszustandes eines induktiven Sensors, insbesondere eines Näherungsschalters, nach dem Oberbegriff des Anspruchs 1.

In einem zweiten Gesichtspunkt bezieht sich die Erfindung auf einen induktiven Sensor, insbesondere einem Näherungsschalter, mit einer Vorbedämpfungserkennung gemäß dem Oberbegriff des Anspruchs 8.

Induktive Näherungsschalter sind mit einem Oszillator ausgestattet, der einen Schwingkreis und einen Oszillationsverstärker aufweist. Zusätzlich besitzen sie eine Auswerte- und Steuereinrichtung. Diese Auswerte- und Steuereinrichtung analysiert das Schwingungsverhalten des Oszillators. Der Oszillator bzw. dessen Schwingkreis wird durch das Vorhandensein von Gegenständen, insbesondere metallischen Gegenständen, beeinflusst, so dass sich das Schwingungsverhalten ändert. Abhängig von der Änderung dieses Schwingungsverhaltens kann rückgeschlossen werden, ob sich ein Objekt, ein so genanntes Target, im Bereich des Näherungsschalters befindet.

Hierbei wird ein Schaltabstand definiert, der den Abstand des Targets zu dem Näherungsschalter angibt, bei dem der Schalter ein Vorhandensein des Targets anzeigt. Dies wird beispielsweise entsprechend einem Schwellwert bei der Analyse des Schwingungsverhaltens des Oszillators erkannt.

Problematisch beim Einbau und Betrieb solcher induktiver Näherungsschalter kann eine so genannte Vorbedämpfung sein. Unter Vorbedämpfung werden alle ungewollten dämpfenden Einwirkungen auf den Näherungsschalter bzw. dessen Oszillator verstanden. Hierunter sind beispielsweise sich im Nahbereich des Oszillators befindliche metallische Gegenstände, aber auch die Struktur der Materialien, die den induktiven Näherungsschalter umgeben, zu verstehen. Grundsätzlich ist es schwer oder gar nicht zu unterscheiden, ob eine Änderung des Schwingungsverhaltens aufgrund einer Vorbedämpfung eintritt oder weil sich ein Target in Nähe des induktiven Näherungsschalters befindet.

Bei einer Bedämpfung, die durch die zuvor beispielhaft aufgezeigten Gegenstände, welche sich im Nahbereich des Oszillators befinden, auftritt, spricht man von einer Vorbedämpfung, da diese Bedämpfung unabhängig von einem Zieltarget auftritt.

Normalerweise erkennt ein induktiver Näherungsschalter das Vorhandensein eines Targets dadurch, dass ein bestimmter Schwellwert bei der Analyse des Schwingungsverhaltens über- oder unterschritten wird. Dieses Verhalten wird durch die Gesamtbedämpfung beeinflusst. Das heißt, abhängig vom Grad der Bedämpfung entscheidet der induktive Näherungsschalter, ob ein Target im Zielbereich ist oder nicht. Ist nun eine Vorbedämpfung vorhanden, so ist der notwendige Gesamtbedämpfungsbetrag, der ein Schaltsignal auslöst, bereits zu einem Teil vorhanden, so dass die Bedämpfung durch das Target geringer ausfallen kann. Dies bedeutet, dass ein Target bereits in einer größeren Entfernung vom Sensor, also bei einem höheren Schaltabstand, ein Schaltsignal auslöst, welches das Vorhandensein eines Targets anzeigt.

Die beschriebenen Effekte führen zu einem unerwünschten Anstieg des Schaltabstands eines induktiven Näherungsschalters.

Ein weiteres Problem ergibt sich dadurch, dass der Oszillator und der in ihm vorgesehene Schwingkreis temperaturabhängig sind. Im Zusammenspiel von Vorbedämpfung und Temperaturdrift kann es in ungünstigen Fällen zu einem Ausfall des induktiven Sensors kommen, da der Sensor eine so genannte Dauerbedämpfung erkennt, das heißt das Vorhandensein eines Targets dauerhaft anzeigt, unabhängig davon, ob ein Target vorhanden ist oder nicht.

Beispielsweise wird von den Nutzern derartiger Sensoren gefordert, dass bei einem Schaltabstand von 12 mm eine Drift des Schaltabstands maximal ± 10 % betragen darf. Dies kann durch entsprechende Maßnahmen in einem vorgegebenen Temperaturbereich von -25°C bis +70°C erreicht werden. Liegt nun bei diesem induktiven Näherungsschalter eine Vorbedämpfung vor, wodurch sich der Schaltabstand auf beispielsweise 20 mm vergrößert hat, so tritt der Temperaturdrift stärker in Erscheinung, so dass es zu der oben beschriebenen Dauerbedämpfung kommen kann.

Daher ist es wünschenswert einen Verdämpfungszustand zu erkennen.

US-6,342,805 betrifft eine Schaltungsanordnung, mit der, abhängig von zwei Eingangsspannungen, ein Schaltmodus eines Sensors, beispielsweise eines induktiven Näherungsschalters, festgelegt werden kann. Ausgehend von einem Stand der Technik, bei dem der Schaltmodus, worunter in diesem Zusammenhang ein "normal offen" oder "normal geschlossen" Zustand verstanden wird, eingestellt wird durch die Polung der angelegten Versorgungsspannung, schlägt US-6,342,805 vor, den Schaltmodus, also "normal offen" oder "normal geschlossen" abhängig vom Spannungspotential zwischen zwei Eingängen einzustellen.

US-7,173,411 bezieht sich auf einen induktiven Näherungsschalter, bei dem durch Auswertung einer Zeitkonstante eines RC-Glieds eine Temperaturbestimmung und damit eine Temperaturkompensation durchgeführt wird. Hierdurch können die Schaltabstände erhöht werden.

Eine **Aufgabe** der Erfindung ist es, ein Verfahren zum Erkennen eines Vorbedämpfungszustands eines induktiven Sensors bereitzustellen, welches sowohl bei geringen wie auch erhöhten Schaltabständen einsetzbar ist. Außerdem soll ein induktiver Sensor geschaffen werden, mit dem eine Vorbedämpfung erkannt werden kann.

Die Aufgabe wird in einem ersten Gesichtspunkt der Erfindung durch das Verfahren zum Erkennen eines Vorbedämpfungszustands eines induktiven Sensors mit den Merkmalen des Anspruchs 1 gelöst.

In einem weiteren Aspekt der Erfindung wird die Aufgabe durch einen induktiven Sensor mit Vorbedämpfungserkennung gemäß dem Anspruch 8 gelöst.

Vorteilhafte Ausführungsformen sind den abhängigen Ansprüchen, der Beschreibung sowie den Figuren und deren Erläuterungen angegeben.

Das bekannte Verfahren ist dadurch erfindungsgemäß weitergebildet, dass das Schwingungsverhalten des Oszillators zusätzlich zu der Analyse bei einer Arbeitsverstärkung auch bei mindestens einer Analyseverstärkung des Oszillationsverstärkers analysiert wird. Diese Analyseverstärkung oder Analyseverstärkungen ist oder sind geringer gewählt als die Arbeitsverstärkung. Außerdem sind die Analyseverstärkung oder Analyseverstärkungen des Oszillationsverstärkers derart gewählt, dass das Schwingungsverhalten des Oszillators empfindlich auf sich im Nahbereich des Sensors befindliche Gegenstände und Objekte reagiert, welche den Sensor vorbedämpfen.

Ein Grundgedanke der Erfindung kann darin gesehen werden, den Oszillator eines induktiven Sensors, insbesondere eines induktiven Näherungsschalters, mit einer Analyseverstärkung zu betreiben. Diese Analyseverstärkung ist geringer als die normale Arbeitsverstärkung, welche bei der Detektion eines Targets verwendet wird. Beim Betrieb des Oszillators mit dieser Analyseverstärkung wird wiederum das Schwingungsverhalten des Oszillators untersucht. Schwingt der Oszillator auch bei der geringeren Analyseverstärkung, so folgt daraus, dass keine oder nur eine sehr geringe Vorbedämpfung vorliegt. Hierbei wird die Analyseverstärkung so gewählt, dass sie einen kritischen Zustand der Vorbedämpfung anzeigen kann. Als kritischer Zustand ist beispielsweise ein Zustand zu verstehen, bei dem durch zusätzliche Abweichungen der Komponenten des Sensors durch Temperaturänderungen eine unzuverlässige Detektion vorliegen würde.

Beim Verwenden von mehreren Analyseverstärkungen ist es beispielsweise möglich, diese so abzustimmen, dass die Auswertung einer ersten Analyseverstärkung ergibt, ob ein kritischer Vorbedämpfungszustand vorliegt, der sofort verändert werden muss, da keine ausreichende Detektionsgenauigkeit mehr zur Verfügung steht. Die Auswertung bei der zweiten Analyseverstärkung kann beispielsweise das Ergebnis liefern, dass zwar eine Vorbedämpfung vorliegt, die allerdings noch nicht so kritisch ist, dass sie sofort verändert werden muss. In diesem Fall würde die zweite Analyseverstärkung stärker als die erste Analyseverstärkung ausgewählt sein. Im Folgenden wird grundsätzlich von einer Analyseverstärkung gesprochen. Erfindungsgemäß ist jedoch darunter auch die Verwendung von mehreren unterschiedlichen Analyseverstärkungen zu verstehen.

Während des Betriebs des Oszillators bei der Analyseverstärkung können keine zuverlässigen Aussagen über das Vorhandensein eines Targets getätigt werden. Deswegen ist es bevorzugt, wenn zumindest für ein Zeitintervall zyklisch zwischen dem Betrieb des Oszillatorverstärkers mit der Arbeitsverstärkung und der Analyseverstärkung umgeschaltet wird. Hierdurch kann sowohl der normale Arbeitszustand des induktiven Sensors erreicht werden, in der er bei Arbeitsverstärkung das Vorhandensein oder Nichtvorhandensein eines Targets erkennt, als auch bei der Analyseverstärkung eine mögliche Vorbedämpfung anzeigt. Diese Vorbedämpfung kann auch beim eingebauten und eingerichteten Sensor, beispielsweise durch neue Komponenten, welche im Nahbereich des Sensors angebracht werden, verändert werden. Grundsätzlich ist es auch möglich, den Sensor lediglich mit der Analyseverstärkung zu betreiben, beispielsweise während des Einbaus und der Positionierung des Sensors, um bereits in diesem Zustand ungünstige Vorbedämpfungsbedingungen zu erkennen und verbessern zu können. Im endgültigen Einsatz erfolgt der Betrieb mit der Arbeitsverstärkung.

Im Rahmen der Analyse des Schwingungsverhaltens des Oszillators können beispielsweise die Frequenz, die Maximalamplitude, der Amplitudenverlauf oder ähnliche signifikante Größen einer Schwingung ausgewertet werden. Bei dem hier aufgeführten Verfahren ist es bereits ausreichend, wenn detektiert wird, ob der Oszillator schwingt oder nicht. So kann bei einem Nichtschwingen des Oszillators bei einer Arbeitsverstärkung des Oszillationsverstärkers auf ein Vorhandensein eines Targets geschlossen werden, welches sich in einem im Vergleich zum Schaltabstand kürzeren Abstand vor dem Sensor befindet. Entsprechend wird ein Schaltsignal ausgegeben. Diese Schlussfolgerung ist allerdings nur dann gültig, wenn keine Vorbedämpfung vorliegt, was mittels des erfinderischen Verfahrens überprüft werden kann.

Das Vorhandensein eines Vorbedämpfungszustands kann ebenfalls allein mittels des Schwingungszustandes des Oszillators bestimmt werden. So wird ein Vorbedämpfungssignal ausgegeben, wenn der Oszillator bei einer Analyseverstärkung nicht schwingt, aber bei einer Arbeitsverstärkung schwingt. Hieraus kann die Schlussfolgerung getroffen werden, dass kein Target in der Nähe ist, da der Oszillator bei der Arbeitsverstärkung schwingt. Da er allerdings bei der Analyseverstärkung nicht schwingt, ist davon auszugehen, dass er in einem kritischen Maß vorbedämpft ist.

Grundsätzlich können die Analyse des Schwingungsverhaltens des Oszillators direkt nach dem Beginn des Betriebs des Oszillationsverstärkers mit der Arbeitsverstärkung oder der Analyseverstärkung ausgeführt werden. Um allerdings dem Oszillator die Möglichkeit zu geben, sich auf die neue Verstärkung einzustellen, um beispielsweise einen quasistationären Zustand der Schwingungen zu erreichen, ist es vorteilhaft, wenn nach dem Umschalten zwischen der Arbeitsverstärkung und der Analyseverstärkung und umgekehrt eine definierte Zeit gewartet wird, bevor die Analyse des Schwingungsverhaltens durchgeführt wird. Dies gilt auch, wenn zwischen verschiedenen Analyseverstärkungen umgeschaltet wird. Diese definierte Wartezeit, welche auch als Wartezeitintervall bezeichnet werden kann, wird bevorzugt abhängig von der Oszillatordynamik gewählt. Das Wartezeitintervall nach dem Umschalten von Arbeits- zu Analyseverstärkung kann sich dabei von dem Wartezeitintervall nach dem Umschalten von Analysezur Arbeitsverstärkung unterscheiden.

Ein besonders zuverlässiges Erkennen eines Vorbedämpfungszustands eines induktiven Näherungssensors wird erreicht, wenn nacheinander folgende Verfahrensschritte durchgeführt werden:
- Schritt 1: Betreiben des Oszillationsverstärkers bei der Arbeitsverstärkung;
- Schritt 2: Analysieren des Schwingungsverhaltens des Oszillators bei der Arbeits- verstärkung des Oszillationsverstärkers;
- Schritt 3: Setzen eines Schaltsignals, falls der Oszillator bei der Arbeitsverstärkung des Oszillationsverstärkers nicht schwingt und Rückkehr zu Schritt 2;
- Schritt 4: Betreiben des Oszillationsverstärkers mit der Analyseverstärkung, falls der Oszillator bei der Arbeitsverstärkung schwingt;
- Schritt 5: Analysieren des Schwingungsverhaltens des Oszillators bei der Analyse- verstärkung des Oszillationsverstärkers;
- Schritt 6: Setzen eines Vorbedämpfungssignals, falls der Oszillator bei der Analyse- verstärkung des Oszillationsverstärkers nicht schwingt;
- Schritt 7: Rückkehr zu Schritt 1.

Zusätzlich können unter Berücksichtigung von Wartezeitintervallen diese in Form von einem Schritt 1a nach Schritt 1 und in Form von einem Schritt 4a nach Schritt 4 eingefügt werden. Hierbei müssen die Wartezeitintervalle von Schritt 1a und 4a nicht gleich sein.

Beim Durchführen der oben genannten Verfahrensschritte kann bei Schritt 3 aus einem Nichtschwingen des Oszillators geschlossen werden, dass es sich um einen stark bedämpften Zustand des induktiven Näherungsschalters handelt. Hieraus wird auf ein Vorhandensein eines Targets geschlossen, da eine Vorbedämpfungszustand durch die nachfolgenden Schritte erkannt und gegebenenfalls abgestellt würde. In Schritt 5 kann daher auf einen Vorbedämpfungszustand geschlossen werden, da dieser Schritt nur erreicht werden kann, wenn der Oszillator bei Arbeitsverstärkung schwingt, also kein Target im Erkennungsbereich vorhanden ist. Wenn nun der Oszillator bei der Analyseverstärkung nicht schwingt, ist die Analyseverstärkung nicht stark genug, um hier die auftretenden Verluste auszugleichen, wie dies durch die Arbeitsverstärkung möglich ist. Daher wird auf eine Vorbedämpfung geschlossen.

Ein gattungsgemäßer induktiver Sensor kann erfindungsgemäß dadurch weitergebildet werden, dass der Oszillationsverstärker zur Verstärkung mit mindestens einer Analyseverstärkung ausgelegt ist. Zusätzlich ist die Auswerte- und Steuereinrichtung zum Erkennen eines Vorbedämpfungszustands durch Analysieren des Schwingungsverhaltens des Oszillators bei einer Arbeitsverstärkung und bei mindestens einer Analyseverstärkung eingerichtet. Hierbei ist die mindestens eine Analyseverstärkung geringer als die Arbeitsverstärkung und so gewählt, dass das Schwingungsverhaltens des Oszillators empfindlich auf sich im Nahbereich des Sensors befindliche Gegenstände reagiert, welche den Sensor vorbedämpfen.

In einer bevorzugten Ausführungsform des induktiven Sensors weist der Oszillationsverstärker eine Verstärkung auf, welche eine steile Amplitudencharakteristik für den Schwingkreis vorgibt. Der Vorteil dieser Amplitudencharakteristik ist, dass die Schaltabstände besonders gut definiert sind. Da der erfindungsgemäße induktive Sensor einen Vorbedämpfungszustand nur durch Analyse des Schwingungsverhaltens des Oszillators erkennt, wobei die Analyse beispielsweise erfolgt durch Tests, ob der Oszillator bei zwei unterschiedlichen Verstärkungen schwingt oder nicht, kann erfindungsgemäß ein Vorbedämpfungszustand auch bei einer steilen Amplitudencharakteristik erkannt werden.

Um ein besonders zuverlässiges Erkennen eines Vorbedämpfungszustands zu erreichen, ist es vorteilhaft, wenn der Oszillationsverstärker bei der Arbeitsverstärkung und bei der Analyseverstärkung eine im Wesentlichen gleiche Verstärkercharakteristik aufweist. Würden sich die Verstärkercharakteristiken stark unterscheiden, so wären die Schlussfolgerungen, wie das Vorliegen eines Vorbedämpfungszustands, welche durch Analysieren des Oszillators bei einer Analyseverstärkung getätigt werden, nicht ohne Weiteres auf die Arbeitsverstärkung übertragbar. Es wären dann entsprechende Umrechnungen nötig.

Die zuvor mit Bezug auf das erfindungsgemäße Verfahren beschriebenen Wartezeiten vor einer Analyse des Schwingungszustands des Oszillators stellen Zeitintervalle dar, die möglichst kurz gehalten werden sollen, da zu diesen Zeitintervallen keine Aussagen bezüglich der Vorbedämpfung oder des Vorhandenseins eines Targets getätigt werden können. Außerdem verlangsamen sie den allgemeinen Messvorgang. Eine Möglichkeit diese Wartezeiten zu verringern, ist, die Verstärkercharakteristik des Oszillationsverstärkers so auszulegen, dass sie ein beschleunigtes Aufschwingen des Oszillators begünstigt. Dies kann beispielsweise dadurch erreicht werden, dass sie im Bereich, in dem der Oszillator mit kleiner Amplitude zu schwingen beginnt, eine größere Verstärkung aufweist, so dass der Oszillator diesen Bereich schnell überschreitet und möglichst schnell in den gewünschten quasi stationären Zustand gelangt.

Bevorzugt weist ein induktiver Sensor sowohl einen Schaltausgang wie auch einen Vorbedämpfungsausgang auf, um das Schalten und das Vorhandensein einer Vorbedämpfung auf separaten Kanälen anzeigen zu können.

Die Erfindung wird nachfolgend anhand eines Ausführungsbeispiels und schematischen Zeichnungen näher erläutert. In diesen Zeichnungen zeigen:
- Fig. 1: eine schematische Darstellung eines erfindungsgemäßen Sensors;
- Fig. 2: eine schematische Darstellung des Verlaufs einer Schwingungsamplitude eines Oszillators in Bezug auf die Entfernung des Targets;
- Fig. 3: eine schematische Darstellung eines Verlaufs von verschiedenen Verstär- kungskurven für einen Oszillationsverstärker; und
- Fig. 4: ein schematisches Flussdiagramm eines erfindungsgemäßen Verfahrens.

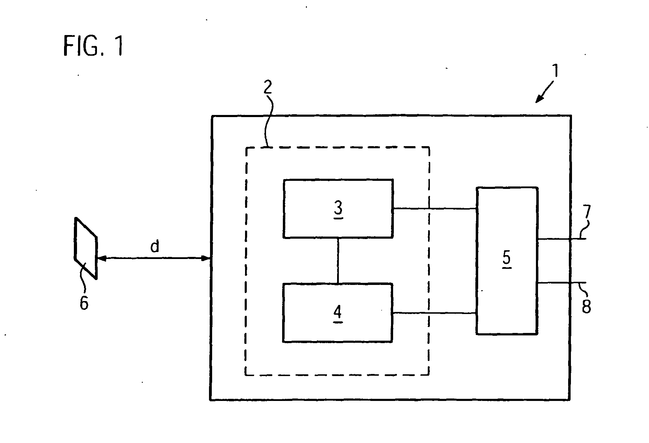

In Fig. 1 ist ein erfindungsgemäßer Sensor 1 mit den für die Erfindung wesentlichen Bauteilen dargestellt. Der Sensor 1 weist einen Oszillator 2 auf. Dieser ist maßgeblich aus einem Schwingkreis 3 und einem Oszillationsverstärker 4 aufgebaut. Der Schwingkreis 3 kann durch den Oszillationsverstärker 4 angeregt werden. Der exakte Aufbau des Schwingkreises 3 ist zum Ausführung der Erfindung nicht relevant und kann abhängig von der genauen Auslegung des Sensors 1 gewählt werden.

Weiterhin weist der Sensor 1 eine Auswerte- und Steuereinheit 5 auf. Diese ist mit dem Oszillationsverstärker 4 und im gezeigten Ausführungsbeispiel mit dem Schwingkreis 3 verbunden. Die Verbindung der Auswerte- und Steuereinheit 5 mit dem Schwingkreis 3 ist optional. Über die Verbindung zum Oszillationsverstärker 4 kann dieser angewiesen werden, mit welcher Verstärkung er die Schwingung im Schwingkreis 3 verstärken soll. Über die Verbindung mit dem Schwingkreis 3 kann die Auswerte- und Steuereinheit 5 Daten über die Schwingung, beispielsweise die Frequenz oder die Amplitude, ermitteln. Ebenso ist darüber feststellbar, ob der Schwingkreis schwingt.

Ferner hat die Auswerte- und Steuereinheit 5 zumindest einen Schaltausgang 7 und einen Vorbedämpfungsausgang 8. Über den Schaltausgang 7 wird ein Signal ausgesendet, wenn ein zu detektierendes Target 6 vorhanden ist. Über den Vorbedämpfungsausgang 8 wird signalisiert, dass sich der Sensor 1 in einem Vorbedämpfungszustand befindet.

Entfernt von dem Sensor 1 befindet sich ein Target 6. Unterschreitet der Abstand zwischen dem Target 6 und dem Sensor 1 einen bestimmten Wert, der als Schaltabstand dₛ bezeichnet wird, so erkennt dies der Sensor 1 und signalisiert auf seinem Schaltausgang 7, dass ein zu detektierendes Target 6 innerhalb des Schaltabstandes dₛ vorhanden ist.

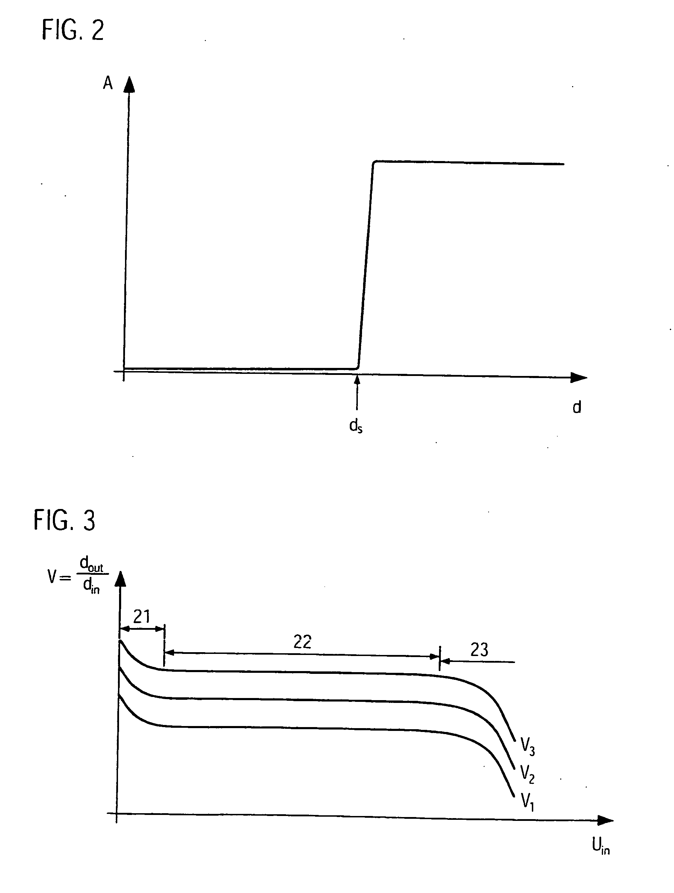

In Fig. 2 ist der gewünschte Verlauf der Schwingungsamplitude in Bezug auf den Abstand des Targets 6 vom Sensor 1 dargestellt. Hierbei ist die Schwingungsamplitude A über den Abstand d dargestellt. Die Verstärkungscharakteristik des Oszillationsverstärkers 4 ist möglichst so eingestellt, dass es zu dem hier dargestellten Amplitudenverlauf kommt.

Fig. 3 zeigt schematisch drei verschiedene Verläufe für die Oszillationsverstärkung. Diese Verläufe werden auch als Charakteristik des Oszillationsverstärkers bezeichnet. Hierbei ist die Eingangsspannung uᵢₙ am Eingang des Oszillationsverstärkers 4 in Bezug auf die Verstarkung, also das Verhältnis der Ausgangsspannung Uₒᵤₜ zur Eingangsspannung uᵢₙ, dargestellt. Der Verlauf einer Verstärkung kann grob in drei Bereiche 21, 22, 23 gegliedert werden. Der Bereich 22, der einen ausgedehnten Linearitätsbereich darstellt, dient dazu, dass bereits kleine Änderungen in der Eingangsspannung uᵢₙ merklich bei der Ausgangsspannung uₒᵤₜ berücksichtigt werden. Dieser Linearbereich 22 führt zu dem abrupten Sprung der Amplitude, sofern das Target 6 den Schaltabstand dₛ unter- oder überschreitet.

Im Bereich 21 ist die Verstärkung größer. Eine derartige Verstärkercharakteristik sorgt dafür, dass ein Oszillator 2 rasch anschwingt und schnell in einen quasistabilen Schwingungszustand übergeführt wird. Der Verlauf stellt also eine Möglichkeit zur Beschleunigung des Anschwingens des Oszillators 2 dar. Der Abfall der Verstärkung im Bereich 23 ist zur Begrenzung der maximalen Amplitude des Oszillators 2 ausgelegt.

In Figur 3 sind exemplarisch drei verschiedene Verstärkungskurven v₁, v₂, v₃ dargestellt. Diese weisen grundsätzlich eine ähnliche Verstärkungscharakteristik auf. Je höher die Verstärkung im Bereich 22 ist, desto höher kann die Bedämpfung des Sensors sein, ohne dass die Schwingung des Oszillators zusammenbricht. Dies bedeutet, dass für einen geringen Schaltabstand dₛ eine größere Verstärkung benötigt wird. Beispielsweise kann die Verstärkung v₃ als Arbeitsverstärkung angesehen werden, während die Verstärkung v₂ und v₁ lediglich zur Analyse des Vorbedämpfungszustandes verwendet werden.

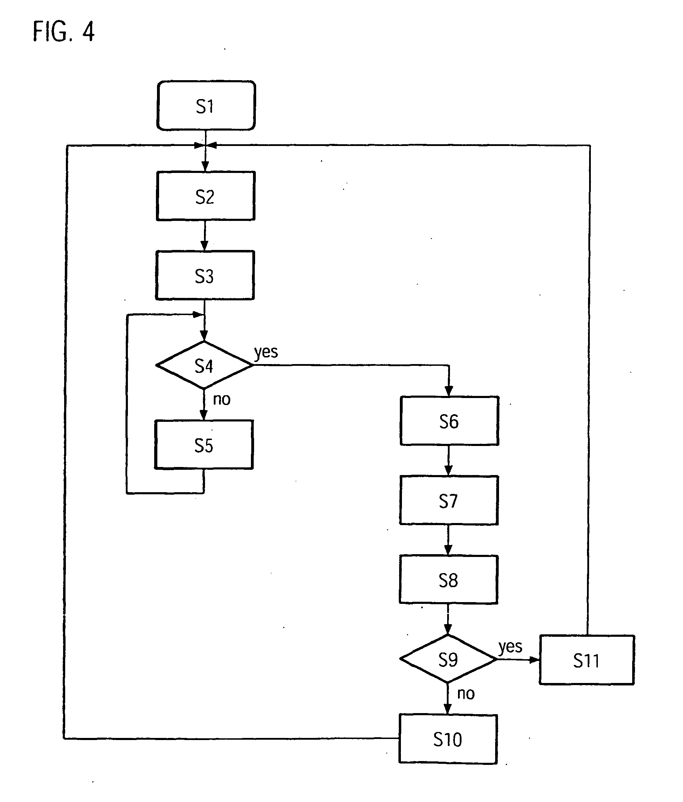

Eine Ausführung des erfindungsgemäßen Verfahrens wird nun anhand des Datenflussdiagramms, welches in Fig. 4 dargestellt ist, näher erläutert. Der erfindungsgemäße Sensor 1 wird im Schritt S1 initialisiert. Anschließend wird im Schritt S2 der Oszillationsverstärker 4 beispielsweise von der Auswerte- und Steuereinheit 5 angewiesen, den Schwingkreis 3 mit einer Arbeitsverstärkung zu betreiben. Dieser Betrieb kann auch als Betrieb mit einem Nominalgain des Oszillationsverstärkers 4 angesehen werden. Dieser Gain ist beispielsweise für einen Schaltabstand dₛ von 10 mm eingerichtet und die Verstärkercharakteristik auf diesen Schaltabstand dₛ hin optimiert.

Anschließend wird im Schritt S3 eine Zeit abgewartet, bevor in den Schritt S4 übergegangen wird. Diese Wartezeit ist abhängig von der Dynamik des Oszillators 2 und dient dazu dem Oszillator 2 eine gewisse Zeit zur Verfügung zu stellen, um in eine zuverlässige, quasistabile Schwingung einzutreten.

Anschließend wird im Schritt S4 untersucht, ob der Oszillator 2 schwingt oder nicht. Diese Untersuchung kann beispielsweise durch die Auswerte- und Steuereinheit 5 durchgeführt werden. Wird in diesem Schritt S4 erkannt, dass der Oszillator 2 bei Anregung mit der Arbeitsverstärkung nicht schwingt, so wird daraus geschlossen, dass sich ein Target 6 im Detektionsbereich befindet. Daher wird im Schritt S5 der Schaltausgang 7 gesetzt. Weiter kann der Vorbedämpfungsausgang 8 auch ausgeschaltet werden, da über eine mögliche Vorbedämpfung in diesem Zustand keinerlei Aussagen getätigt werden können. Zusätzlich ist es möglich eine Bedämpfungsanzeige vorzusehen, die die grundsätzliche Bedämpfung des Sensors 1 anzeigt. Diese würde hierbei mit Schritt S5 eingeschaltet werden. Anschließend wird zum Schritt S4 gewechselt, um ein Schwingen des Oszillators 2 erneut zu untersuchen.

Wird im Schritt S4 aber detektiert, dass der Oszillator 2 schwingt, so wird auf den Schritt S6 übergegangen, in dem der Schaltausgang 7 und die optional vorgesehene Bedämpfungsanzeige auf AUS gesetzt werden, und damit angezeigt, dass keine Bedämpfung vorliegt und kein Target 6 im Detektionsbereich befindlich ist. Die Schlussfolgerung aus dem Schwingen des Oszillators 2 im Schritt S4 ist, dass sich kein Target im Detektionsbereich befindet.

Anschließend werden die Schritte S7 bis S9 und S10 oder S11 durchgeführt, um das Vorhandensein einer Vorbedämpfung zu überprüfen. Im Schritt S7 wird der Gain des Oszillationsverstärkers 4 reduziert, so dass der Oszillationsverstärker 4 den Schwingkreis 3 mit einer Analyseverstärkung anregt. Diese Stärke der Analyseverstärkung ist so eingestellt, dass hierdurch ein kritischer Vorbedämpfungszustand erkannt werden kann. Bevorzugt wird diese Einstellung erst im eingebauten Zustand eines Sensors 1 durchgeführt, so dass die Umgebungsvariablen berücksichtigt werden können.

Anschließend wird im Schritt S8 wiederum ein Zeitintervall abgewartet, damit sich der Schwingkreis 3 auf einen stationären Schwingungszustand einstellen kann.

Auf den Schritt S8 folgend wird im Schritt S9 erneut das Schwingungsverhalten des Oszillators 2 analysiert. Schwingt der Oszillator 2, so folgt daraus, dass keine Vorbedämpfung vorhanden ist. Daher wird im Schritt S11 die Vorbedämpfungsanzeige auf AUS gestellt. Im Gegensatz dazu wird im Schritt S10, wenn der Oszillator 2 nicht schwingt, auf eine Vorbedämpfung geschlossen und demnach die Vorbedämpfungsanzeige auf EIN geschaltet. Anschließend wird entweder von Schritt S10 oder S11 zurück zum Schritt S2 gewechselt, um das Vorhandensein eines Targets 6 zu detektieren.

Das erfindungsgemäße Verfahren und die erfindungsgemäße Vorrichtung bieten somit die Möglichkeit, einen unerwünschten kritischen Vorbedämpfungszustand unabhängig von der exakten Auslegung des Sensors zu erkennen.

## Patentansprüche

1. Verfahren zum Erkennen eines Vorbedämpfungszustands eines induktiven Sensors (1), insbesondere eines Näherungsschalters,
welcher einen Oszillator (2) mit einem Schwingkreis (3) und mit einem Oszillationsverstärker (4) aufweist,
bei dem das Schwingungsverhalten des Oszillators (2) bei einer Arbeitsverstärkung des Oszillationsverstärkers analysiert wird (S4) und
**dadurch gekennzeichnet,**
**dass** das Schwingungsverhalten des Oszillators (2) bei mindestens einer Analyseverstärkung des Oszillationsverstärkers analysiert wird (S9),
**dass** die mindestens eine Analyseverstärkung geringer als die Arbeitsverstärkung gewählt wird und
**dass** die mindestens eine Analyseverstärkung des Oszillationsverstärkers so gewählt wird, dass das Schwingungsverhalten des Oszillators (2) empfindlich auf sich im Nahbereich des Sensors (1) befindliche Gegenstände reagiert, welche den Sensor vorbedämpfen.

2. Verfahren nach Anspruch 1,
**dadurch gekennzeichnet,**
**dass** zumindest für ein Zeitintervall zyklisch zwischen dem Betrieb des Oszillationsverstärkers mit der Arbeitsverstärkung (S2) und der Analyseverstärkung (S7) umgeschaltet wird.

3. Verfahren nach einem der Ansprüche 1 oder 2,
**dadurch gekennzeichnet,**
**dass** ein Schaltsignal ausgegeben wird, wenn der Oszillator (2) bei der Arbeitsverstärkung nicht schwingt (S6).

4. Verfahren nach einem der Ansprüche 1 bis 3,
**dadurch gekennzeichnet,**
**dass** ein Vorbedämpfungssignal ausgegeben wird, wenn der Oszillator (2) bei der Analyseverstärkung nicht schwingt und bei der Arbeitsverstärkung (S10) schwingt.

5. Verfahren nach einem der Ansprüche 1 bis 4,
**dadurch gekennzeichnet,**
**dass** die Analyse des Schwingungsverhaltens (S4, S9) des Oszillators (2) nach dem Umschalten zwischen Arbeitsverstärkung und Analyseverstärkung und umgekehrt nach einem Wartezeitintervall (S3, S8) ausgeführt wird.

6. Verfahren nach Anspruch 5,
**dadurch gekennzeichnet,**
**dass** das Wartezeitintervall (S3, S8) abhängig von der Oszillatordynamik gewählt wird.

7. Verfahren nach einem der Ansprüche 1 bis 6,
**dadurch gekennzeichnet,**
**dass** nacheinander folgende Verfahrensschritte durchgeführt werden:
a) Betreiben des Oszillationsverstärkers (4) bei der Arbeitsverstärkung (S2);
b) Analysieren des Schwingungsverhaltens des Oszillators (2) bei der Arbeitsverstärkung (S4);
c) Setzen eines Schaltsignals, falls der Oszillator (2) bei der Arbeitsverstärkung nicht schwingt (S5) und Rückkehr zu Schritt b);
d) Betreiben des Oszillationsverstärkers (4) mit der Analyseverstärkung (S7);
e) Analysieren des Schwingungsverhaltens des Oszillators (2) bei der Analyseverstärkung des Oszillationsverstärkers (4) (S9);
f) Setzen eines Vorbedämpfungssignals falls der Oszillator (2) bei der Analyseverstärkung nicht schwingt (S10),
g) Rückkehr zu Schritt a).

8. Induktiver Sensor, insbesondere Näherungsschalter, mit Vorbedämpfungserkennung,
mit einem Oszillator (2), welcher einen Schwingkreis (3) und einen Oszillationsverstärker (4) aufweist,
mit einer Auswerte- und Steuereinrichtung (5) zum Analysieren des Schwingungsverhaltens des Oszillators (2),
wobei der Oszillationsverstärker (4) zur Verstärkung mit einer Arbeitsverstärkung ausgelegt ist,
**dadurch gekennzeichnet,**
**dass** der Oszillationsverstärker (4) zur Verstärkung mit mindestens einer Analyseverstärkung ausgelegt ist,
**dass** die Auswerte- und Steuereinrichtung (5) zum Erkennen eines Vorbedämpfungszustands durch Analysieren des Schwingungsverhaltens des Oszillators (2) bei einer Arbeitsverstärkung und bei mindestens einer Analyseverstärkung eingerichtet ist,
**dass** die mindestens eine Analyseverstärkung geringer als die Arbeitsverstärkung ist, und
**dass** die mindestens eine Analyseverstärkung des Oszillators (2) so gewählt ist, dass das Schwingungsverhalten des Oszillators (2) empfindlich auf sich im Nahbereich des Sensors befindliche Gegenstände reagiert, welche den Sensor vorbedämpfen.

9. Induktiver Sensor nach Anspruch 8,
**dadurch gekennzeichnet,**
**dass** der Oszillatorverstärker (4) eine Verstärkung aufweist, welche eine steile Amplitudencharakteristik für den Schwingkreis (3) vorgibt.

10. Induktiver Sensor nach einem der Ansprüche 8 oder 9,
**dadurch gekennzeichnet,**
**dass** der Oszillationsverstärker (4) bei Arbeitsverstärkung und bei Analyseverstärkung eine im Wesentlichen gleiche Verstärkercharakteristik aufweist.

11. Induktiver Sensor nach einem der Ansprüche 8 bis 10,
**dadurch gekennzeichnet,**
**dass** die Verstärkercharakteristik des Oszillationsverstärkers (4) zum beschleunigten Aufbauen der Schwingung des Oszillators (2) ausgelegt ist.

12. Induktiver Sensor nach einem der Ansprüche 8 bis 11,
**dadurch gekennzeichnet,**
**dass** der Sensor (1) einen Schaltausgang (7) und einen Vorbedämpfungsausgang (8) aufweist.

## Claims

1. Method for the detection of a predamping state of an inductive sensor (1), particularly a proximity switch, which has an oscillator (2) with a resonant circuit (3) and an oscillation amplifier (4),
in which the oscillatory response of the oscillator (2) is analyzed with an operating amplification of the oscillation amplifier (S4) and
**characterized in that**
the oscillatory response of the oscillator (2) is analyzed with at least one analysis amplification of the oscillation amplifier (S9),
the at least one analysis amplification is chosen lower than the operating amplification and
the at least one analysis amplification of the oscillation amplifier is chosen in such a way that the oscillatory response of the oscillator (2) reacts sensitively to objects located in the vicinity of the sensor (1) and which predamp said sensor.

2. Method according to claim 1,
**characterized in that**
cyclic switching between the operation of the oscillation amplifier with operating amplification (S2) and analysis amplification (S7) takes place at least for a time interval.

3. Method according to claim 1 or 2,
**characterized in that**
a switching signal is emitted if the oscillator (2) does not oscillate during operating amplification (S6).

4. Method according to one of the claims 1 to 3,
**characterized in that**
a predamping signal is emitted if the oscillator (2) does not oscillate during analysis amplification and oscillates during operating amplification (S10).

5. Method according to one of the claims 1 to 4,
**characterized in that**
the analysis of the oscillatory response (S4, S9) of the oscillator (2) takes place following switching between operating amplification and analysis amplification and vice versa following a waiting time interval (S3, S8).

6. Method according to claim 5,
**characterized in that**
the waiting time interval (S3, S8) is chosen as a function of the oscillator dynamics.

7. Method according to one of the claims 1 to 6,
**characterized in that**
successively the following method steps are performed:
a) operating the oscillation amplifier (4) with operating amplification (S2);
b) analyzing the oscillatory response of the oscillator (2) with operating amplification (S4);
c) setting a switching signal if the oscillator (2) does not oscillate at the operating amplification (S5) and return to step b);
d) operating the oscillation amplifier (4) with analysis amplification (S7);
e) analyzing the oscillatory response of the oscillator (2) for analysis amplification of the oscillation amplifier (4) (S9);
f) setting a predamping signal if the oscillator (2) does not oscillate with analysis amplification (S10);
g) return to step a).

8. Inductive sensor, particularly a proximity switch, with predamping detection, with an oscillator (2) having a resonant circuit (3) and an oscillation amplifier (4), with an evaluating and control device (5) for analyzing the oscillatory response of the oscillator (2),
the oscillation amplifier (4) being designed for amplification with an operating amplification,
**characterized in that**
the oscillation amplifier (4) is designed for amplification with at least one analysis amplification,
the evaluating and control device (5) is set up for detecting a predamping state by analyzing the oscillatory response of the oscillator (2) with an operating amplification and with at least one analysis amplification,
the at least one analysis amplification is lower than the operating amplification and
the at least one analysis amplification of the oscillator (2) is chosen in such a way that the oscillatory response of the oscillator (2) reacts sensitively to objects located in close proximity to the sensor and which predamp the sensor.

9. Inductive sensor according to claim 8,
**characterized in that**
the oscillation amplifier (4) has a gain presetting a steep amplitude characteristic for the resonant circuit (3).

10. Inductive sensor according to one of the claims 8 or 9,
**characterized in that**
the oscillation amplifier (4) has substantially identical amplifier characteristics for operating amplification and analysis amplification.

11. Inductive sensor according to one of the claims 8 to 10,
**characterized in that**
the amplifier characteristic of the oscillation amplifier (4) is designed for the accelerated buildup of the oscillation of the oscillator (2).

12. Inductive sensor according to one of the claims 8 to 11,
**characterized in that**
the sensor (1) has a switching output (7) and a predamping output (8).

## Revendications

1. Procédé de détection d'un état de pré-atténuation d'un capteur inductif (1), en particulier d'un capteur de proximité,
qui comprend un oscillateur (2) avec un circuit oscillant (3) et avec un amplificateur d'oscillations (4),
dans lequel le comportement oscillatoire de l'oscillateur (2) est analysé (S4) lors d'une amplification de travail de l'amplificateur d'oscillations, et
***caractérisé***
***en ce que*** le comportement oscillatoire de l'oscillateur (2) est analysé (S9) lors d'au moins une amplification d'analyse de l'amplificateur d'oscillations,
***en ce que*** ladite au moins une amplification d'analyse est choisie plus faible que l'amplification de travail, et
***en ce que*** ladite au moins une amplification d'analyse de l'amplificateur d'oscillations est choisie de façon que le comportement oscillatoire de l'oscillateur (2) réagisse de manière sensible à des objets présents dans la zone de proximité du capteur (1), qui pré-atténuent le capteur.

2. Procédé selon la revendication 1,
***caractérisé***
***en ce qu*'**au moins pendant un intervalle de temps, on commute de manière cyclique entre le fonctionnement de l'amplificateur d'oscillations avec l'amplification de travail (S2) et l'amplification d'analyse (S7).

3. Procédé selon la revendication 1 ou 2,
***caractérisé***
***en ce qu*'**un signal de commutation est délivré lorsque l'oscillateur (2) n'oscille pas avec l'amplification de travail (S6).

4. Procédé selon l'une quelconque des revendications 1 à 3,
***caractérisé***
***en ce qu*'**un signal de pré-atténuation est délivré lorsque l'oscillateur (2) n'oscille pas avec l'amplification d'analyse et oscille avec l'amplification de travail (S10).

5. Procédé selon l'une quelconque des revendications 1 à 4,
***caractérisé***
***en ce que*** l'analyse du comportement oscillatoire (S4, S9) de l'oscillateur (2) est effectuée après la commutation entre amplification de travail et amplification d'analyse et inversement, après un intervalle de temps d'attente (S3, S8).

6. Procédé selon la revendication 5,
***caractérisé***
***en ce que*** l'intervalle de temps d'attente (S3, S8) est choisi en fonction de la dynamique de l'oscillateur.

7. Procédé selon l'une quelconque des revendications 1 à 6,
***caractérisé***
***en ce que*** les étapes de procédé suivantes sont effectuées successivement :
a) fonctionnement de l'amplificateur d'oscillations (4) avec l'amplification de travail (S2) ;
b) analyse du comportement oscillatoire de l'oscillateur (2) avec l'amplification de travail (S4) ;
c) activation d'un signal de commutation si l'oscillateur (2) n'oscille pas avec l'amplification de travail (S5) et retour à l'étape b) ;
d) fonctionnement de l'amplificateur d'oscillations (4) avec l'amplification d'analyse (S7) ;
e) analyse du comportement oscillatoire de l'oscillateur (2) avec l'amplification d'analyse de l'amplificateur d'oscillations (4) (S9) ;
f) activation d'un signal de pré-atténuation si l'oscillateur (2) n'oscille pas avec l'amplification d'analyse (S10) ;
g) retour à l'étape a).

8. Capteur inductif, en particulier capteur de proximité, à détection de pré-atténuation avec un oscillateur (2) qui comprend un circuit oscillant (3) et un amplificateur d'oscillations (4),
avec un dispositif d'analyse et de commande (5) pour analyser le comportement oscillatoire de l'oscillateur (2),
dans lequel l'amplificateur d'oscillations (4) est conçu pour amplifier avec une amplification de travail,
***caractérisé***
***en ce que*** l'amplificateur d'oscillations (4) est conçu pour amplifier avec au moins une amplification d'analyse,
***en ce que*** le dispositif d'analyse et de commande (5) est agencé pour détecter un état de pré-atténuation par analyse du comportement oscillatoire de l'oscillateur (2) avec une amplification de travail et avec au moins une amplification d'analyse, *en ce que* ladite au moins une amplification d'analyse est plus faible que l'amplification de travail, et
***en ce que*** ladite au moins une amplification d'analyse de l'oscillateur (2) est choisie de façon que le comportement oscillatoire de l'oscillateur (2) réagisse de manière sensible à des objets présents dans la zone de proximité du capteur, qui pré-atténuent le capteur.

9. Capteur inductif selon la revendication 8,
***caractérisé***
***en ce que*** l'amplificateur d'oscillations (4) présente une amplification qui impose une caractéristique d'amplitudes raide pour le circuit oscillant (3).

10. Capteur inductif selon l'une quelconque des revendications 8 ou 9,
***caractérisé***
***en ce que*** l'amplificateur d'oscillations (4) présente une caractéristique d'amplification essentiellement identique à l'amplification de travail et à l'amplification d'analyse.

11. Capteur inductif selon l'une quelconque des revendications 8 à 10,
***caractérisé***
***en ce que*** la caractéristique d'amplificateur de l'amplificateur d'oscillations (4) est conçue pour instaurer de manière accélérée l'oscillation de l'oscillateur (2).

12. Capteur inductif selon l'une quelconque des revendications 8 à 11,
***caractérisé***
***en ce que*** le capteur (1) comprend une sortie de commutation (7) et une sortie de pré-atténuation (8).
